(19) **Europäisches Patentamt / European Patent Office / Office européen des brevets**

(11) **EP 2 722 988 B1**

(12) **EUROPEAN PATENT SPECIFICATION**

(45) Date of publication and mention
of the grant of the patent:
**19.06.2019 Bulletin 2019/25**

(51) Int Cl.:
*H03K 17/96* (2006.01)     *G06F 3/044* (2006.01)
*G06F 3/041* (2006.01)

(21) Application number: **12461552.7**

(22) Date of filing: **16.10.2012**

(54) **A method of the touch detection for capacitive touch sensors**

Verfahren der Berührungserfassung für kapazitative Berührungssensoren

Procédé de détection tactile pour des capteurs tactiles capacitifs

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**23.04.2014 Bulletin 2014/17**

(73) Proprietor: **Diehl AKO Stiftung & Co. KG
88239 Wangen (DE)**

(72) Inventor: **Masina, Pawel
98-270 Zloczew (PL)**

(74) Representative: **Diehl Patentabteilung
c/o Diehl Stiftung & Co. KG
Stephanstraße 49
90478 Nürnberg (DE)**

(56) References cited:
**DE-A1-102010 030 374     GB-A- 2 119 931
US-A1- 2004 239 535     US-A1- 2011 221 488**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF INVENTION

The present invention relates generally to a field of capacitive touch sensors, and more particularly to a method of the touch detection for capacitive touch sensors.

BACKGROUND OF INVENTION

Capacitive touch sensors such as touch buttons are nowadays widely known and used in various electronic devices, control panels, user interfaces, mobile phones, tablets, calculators, etc and they are still growing popular. They have successfully replaced former push-buttons or mechanical switches well known from the prior art. In contrast to the latter, capacitive touch buttons do not need to be manually switched by applying a force (e.g., biased, pressed etc.), but they use a detection of capacitance change that occurs when, for example, an user put his finger in close proximity to the capacitive touch button. The capacitive touch buttons have many advantages over mechanical buttons, due to their versatility, reliability, robustness and lower costs. The principle of the operation of the capacitive buttons is based on the effect of electric charge change at the electrode (being a sensing area) which depends on a presence of, e.g. a human finger or other object close to the electrode. A most common solution employs an electronic driver, e.g. microcontroller that continually charges the electrode by applying a fixed amount of current for a predetermined time period. After the predetermined time period elapses a difference between the high and low voltages at the electrode is measured. If another conducting object comes into proximity of the electrode, e.g. a human finger, the difference of the measured voltage changes because of the capacitance change.

Up to now, several solutions of capacitive touch switch were used.

A United States Patent No. US 7,375,656 B2, Bernd Raunig, describes a circuit configuration for a capacitive touch switch which contains at least one sensor circuit with a capacitive sensor element which changes its capacitance value when touched, and an evaluation circuit which is supplied with an output signal from the sensor circuit in order to determine whether the capacitive sensor element is actuated or not.

A United States Patent Application No. US 2007/0181412 A1, Müller et al., describes a capacitive touch switch which is used, for example, in a control device for an electronic domestic appliance, which includes a sensor area as part of a capacitance sensor element having a capacitance which changes when the element is touched.

A document DE 10 2010 030374 A1, ATMEL CORP, describes an electronic apparatus and a method of operating the electronic apparatus. The method comprises acquiring a first response from an output line, the first response being a signal derived from a rising edge of a waveform; acquiring a second response from the output line, the second response being a signal derived from a falling edge of the waveform; and manipulating the first response and the second response to reject noise at frequencies less than a frequency associated with the waveform. However, the above-mentioned solutions are either no cost effective, too sensitive for high frequency noise, have a low sensitivity of the capacitance change detection or they require active and/or sophisticated elements.

Therefore, there is a need in the art for a method for detecting an actuation of capacitive touch sensors that provides resistance to the electromagnetic interference and which is reliable and easy to perform.

The aim of the present invention is to provide a method of the touch detection for capacitive touch sensors which is independent of the microcontroller architecture and which enables measuring and detecting a small capacitance change e.g. for capacitance touch buttons/keyboards/sliders. It is highly desirable for the method to solve the high frequency noise problem in the capacitance touch technology.

SUMMARY OF THE INVENTION

According to the present invention there is provided a method of touch detection for capacitive touch sensors according to the appended independent claim 1.

Preferably, the measurement is performed immediately after the signal changes its level from low to high and/or from high to low.

Preferably, the measuring circuit is an analog-to-digital converter.

Preferably, the measuring circuit is connected to the capacitive touch sensor through said resistor and another electronic element providing a resistance to the electromagnetic interference (EMI).

Preferably, the capacitive touch sensor is either a separate button or elements of a slider or a wheel.

Preferably, the voltage/current source is connected via multiple inverted polarized diodes to multiple capacitive touch sensors, which are connected via multiple resistors to the measuring circuit with use of a line expander.

Preferably, the line expander is an analog multiplexer.

Preferably, the voltage/current source and/or the measuring circuit are incorporated into an integrated circuit.

The method according to the present invention helps to solve the problem of electromagnetic interference (EMI), provides the independency from a microcontroller platform, enables measuring and detecting a small capacitance change of capacitive touch sensors and it does not require expensive and complex components. The method of a touch detection uses the signal values obtained with the use of a capacitive voltage divider. The measurement of a signal by a measuring circuit is performed as soon as possible after the change of the level of the stimulating signal.

BRIEF DESCRIPTION OF THE DRAWINGS

Embodiments of the present invention will now be described, by way of an example, with reference to the accompanying drawings in which:

Fig. 1 presents an exemplary electrical circuit arrangement employing a processor and a capacitive voltage divider ;

Fig. 2 presents a general rule of using a capacitive voltage divider;

Fig. 3 presents an exemplary electrical circuit arrangement employing a processor and a configuration of the capacitive voltage divider for performing the method according to the present invention.

Fig. 4 presents a flow diagram illustrating the method according to the present invention.

Fig. 5 presents rules of functioning of an exemplary touch detection algorithm that may be used in the method according to the present invention.

Fig. 6 presents exemplary courses for determining the actuation of the capacitive touch sensor in accordance with the present invention;

Fig. 7 presents an exemplary electrical circuit arrangement employing an analog multiplexer for multiple capacitive touch sensors.

DETAILED DESCRIPTION

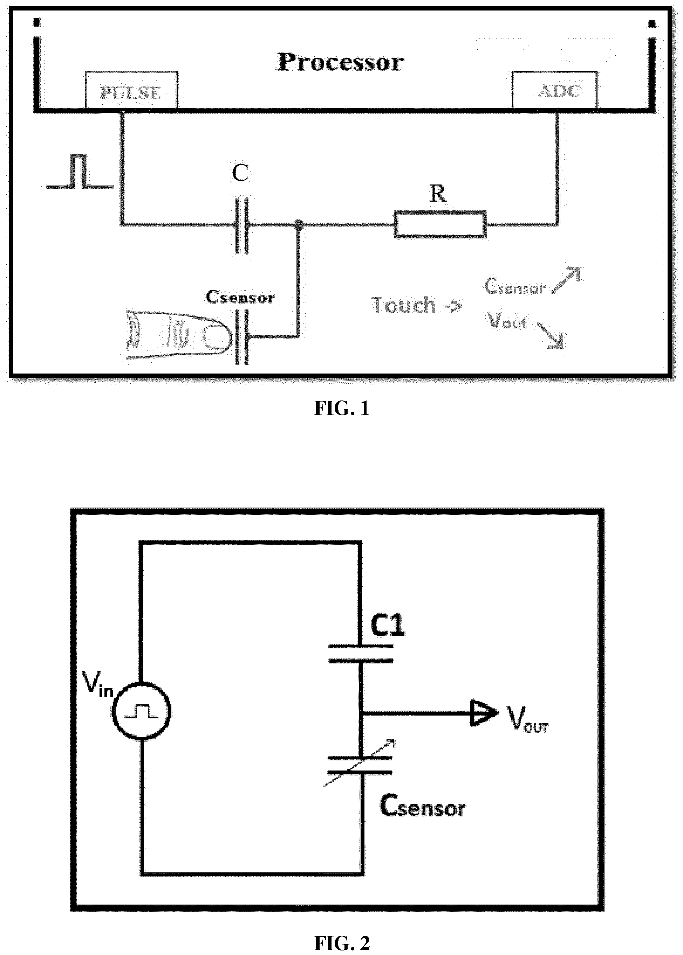

Fig. 1 presents the exemplary electrical circuit arrangement employing a processor and a detection circuit embodied as a capacitive voltage divider . A capacitive touch sensor Csensor activated by e.g. a human finger causes an increase of the capacity of the Csensor. This increase of the capacity causes a drop of the signal level, e.g. a voltage signal level, on the output detection circuit which in the present example is a capacitive voltage divider formed by the capacitor C and the Csensor. The resistor R located at the output of the detection circuit effectively increases the immunity to EMI and thus improves the detection accuracy. In the present embodiment, the mentioned drop of a signal level is detected by stimulating a sensing circuit by changing the output signal level of the PULSE pin of the processor and immediately measuring a signal level at the ADC (Analog-to-Digital Converter) pin of the processor. Then, values for one or more measurements are compared in order to determine, by means of e.g. a suitable touch detection algorithm, whether the capacitive touch sensor was actuated.

A general rule of functioning of a voltage divider which may be employed as the detection circuit is presented in Fig. 2. The detection circuit consisting of two elements, capacitors C1 and the Csensor produces an output voltage $V_{OUT}$ depending on $C_1$ and $C_{sensor}$ capacity values. $V_{IN}$ is an input voltage. A change of the voltage in the detection circuit is determined by the following equation:

$$V_{OUT} = \frac{C_1}{C_1 + C_{sensor}} \bullet V_{IN}$$

where:

$C_1$ is the capacity of the capacitor C1;
$C_{sensor}$ is the capacity of the capacitor Csensor.

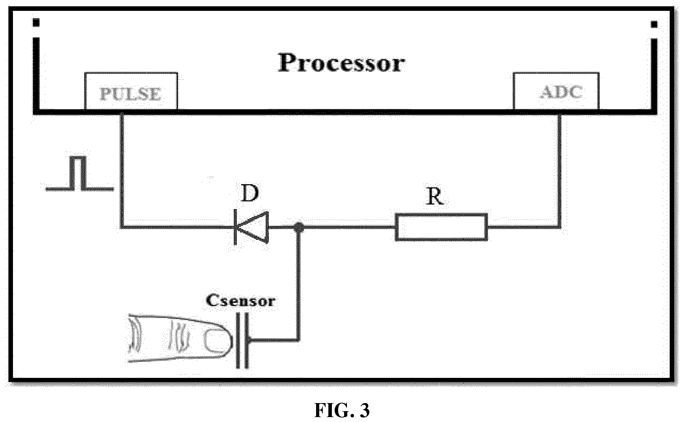

As it can be easily noticed, any change of the $C_{sensor}$ value of the Csensor, caused by, for example, a human finger has an effect on output voltage $V_{OUT}$. Alternatively, the voltage divider employed in the sensing circuit can also consist of other elements, as for example a capacitor and a resistor, or a capacitor and according to the invention a diode as it can be seen in Fig. 3 where an electrical circuit arrangement employing an capacitive voltage divider consisting of an inverted polarized diode D (pn junction) and the Csensor, and a resistor R is presented for performing the method according to the invention. Similarly as in the embodiment presented in Fig. 1, the Csensor represents a first capacitance that characterizes the capacitive touch sensor, said capacitance changing when the capacitive touch sensor is touched by, e.g. a human finger. As the second capacitance, the p-n junction capacitance is used which depends on the diode characteristics.

In other embodiments an independent voltage/current source and/or a sensing circuit may be used and they may be controlled by an external control device or a processor. In some embodiments, the voltage/current source and/or the sensing circuit may be incorporated into any integrated circuit. It may be advantageous to use an independent voltage/current source to achieve a better repeatability of stimulating pulses or efficiency, for example, when using a number of capacitive touch sensors in one circuit arrangement.

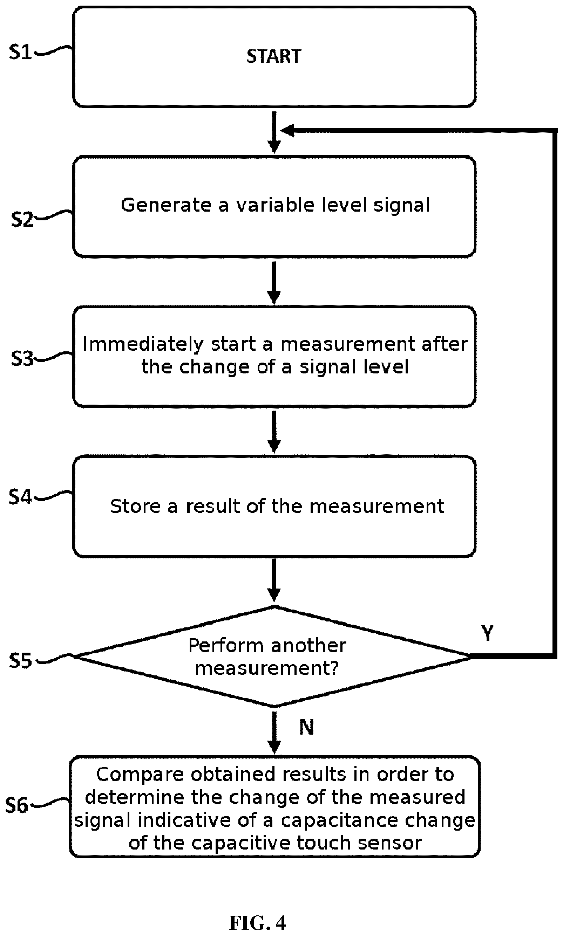

According to the present invention, the main principle of the method is to perform a measurement of the voltage level as quickly as possible after stimulating the change of the output signal level. Fig. 4 presents a flow diagram illustrating the method according to the present invention. The method starts in the step S1. In the step S2 a variable level signal is generated by a voltage/current source which in one embodiment may be one of the processor ports, for example, as illustrated in Fig. 1 or Fig. 3. Then, immediately after the change of a signal level, in the step S3, the output signal is measured by a measuring circuit which may be an analog-to-digital converter either stand-alone or incorporated into a control device or a processor, as illustrated in Fig. 1 or Fig. 3 where the ADC input of processor is used. In the typical realization a signal level change from low to high is used. However, it is also possible to perform the measurement after the change of a signal level from high to low or even both these approaches may be used to perform double-check measurements (i.e. measurements are made after the change of a signal level both from high to low and low to high). In case of the double-check measurement the method exhibits a higher resistance to interferences. In the step S4 the result of measurement is stored e.g. in a memory of the measuring circuit. The memory can also be of any type of a storing device which is suitable for storing information regarding measured values. In the step S5 a decision is made whether to perform another measurement or not. If other measurements are required, for example in order to collect a predetermined number of values needed to perform a touch detection, the method returns to the step S2. Otherwise, in the step S6, the results of measurements are compared in order to determine a change of the measured signal which is indicative of a capacitance change of the capacitive touch sensor Csensor. There are many possible touch detection algorithms which can be used to perform the step S6, that are based on collected values of performed measurements and which allow to accurately detect the actuation of the capacitive touch sensor.

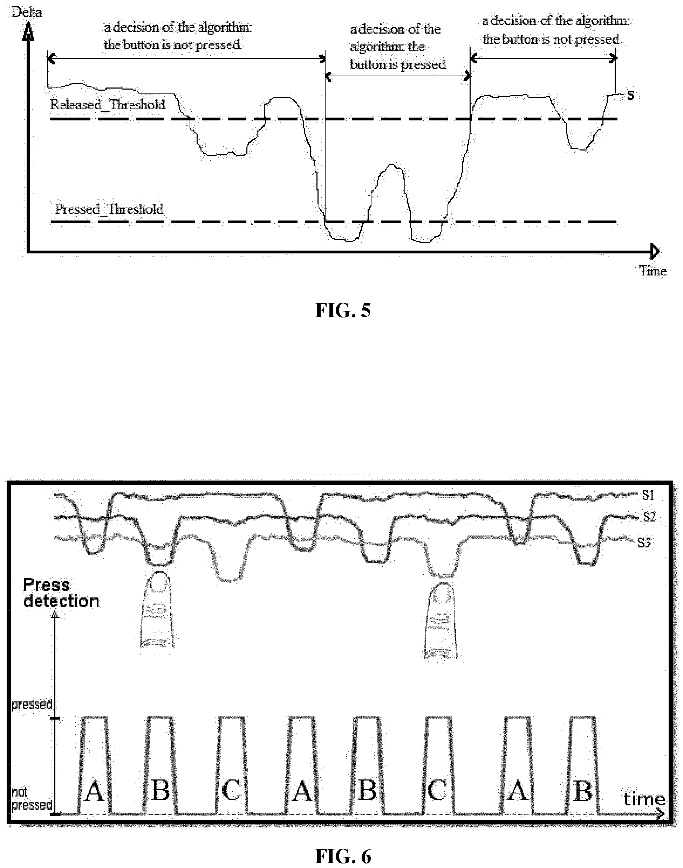

The method of the present invention, in one embodiment, employs a filtering algorithm which is used for the correct detection of touching. Basic rules of the functioning of an exemplary touch detection algorithm which can be used to perform the step S6 of the method are presented in Fig. 5. The algorithm allows to provide the resistance to a high-frequency external noise in the presented method. The algorithm effectively increases the immunity to EMI. The touch detection algorithm will be described now. In Fig. 5 there are shown only results of the algorithm. The algorithm is as follows.

At the beginning an initial value of a voltage is measured by ADC (without a touch). The value measured by the ADC is stored in a memory as "Vnow". It provides a basis for the future comparison. Then, the next measurement of a voltage is made, i.e. "Vnext". If a value of the measured voltage at a given moment is lower than the previous value of the voltage, the algorithm reduces the specified variable called e.g. "DECIM". In this way the decimation for the next measured values of a voltage from a capacitive voltage divider is performed. If the next measured voltage on the capacitive divider is higher, then the value of variable "DECIM" is incremented. The second variable called "Long_Button" which is used in the algorithm, at the beginning is set to value 0.

In other words, if the currently measured value of the voltage is higher than the previous one, "DECIM" is incremented by 1. In the situation when the currently measured value of the voltage of the capacitive voltage divider is lower than the previous one, "DECIM" is decreased by 1.

if "Vnext" > "Vnow" then "DECIM" + 1
if "Vnext" < "Vnow" then "DECIM" - 1

Consecutive values of the variable "DECIM" are added together and create a second variable "Long_Button". The variable "Long_Button" is the result of adding 128 consecutive values of the variable "DECIM".

The initial value "DECIM" may be zero, but for a rapid adaptation to external conditions it is better to set e.g. DECIM = 100.

The decimation is performed for 128 samples. Measurements made by ADC are performed at different time intervals. Different time intervals between consecutive measurements of the method allow to obtain a better noise resistance.

After processing 128 samples (the consecutive values from the measurements made by ADC), the second step of the algorithm is performed - a touch detection. ADC freezes the action for the time necessary for the step of a touch detection.

In the next step, the variable called "Word_Result" is set to the value "Long_Button" with bits shifted to the right by 5 places (divided by 32). Then the "Long Button" is set to zero, which - according to the present invention - allows to collect new (future) 128 samples from the ADC.

"Word_Result" = "Long_Button" / 32
and next
"Long_Button" = 0

Generally, touching by e.g. a human finger causes a voltage drop on the capacitive divider. In consequence, the value "Word_Result" is reduced.

Then the algorithm calculates the value of a variable called "Delta" which is calculated as the difference between "Word_Result" and "Average_sensor_data" divided by 16. "Average_sensor_data" will be described in details later.

$$\text{``Delta''} = \text{"Word\_Result"} - \text{"Average\_sensor\_data"} / 16$$

The sensitivity detection algorithm is defined via two fixed thresholds: "Released_Threshold" and "Pressed_Threshold" which are indicated in Fig. 5. Values of "Released_Threshold" and "Pressed_Threshold" are chosen in an experimental way depending on the hardware characteristic. Many factors are important here, for example such as: the length of connections on the PCB, the thickness of the tracks on a PCB board and mechanical parameters of buttons.

Therefore, the value of "Released_threshold" and "Pressed_threshold" are chosen individually for each project (pcb design).

The following values can be assumed:

"Released_Threshold" = -30
"Pressed_Threshold" = -60

As it can be observed in Fig. 5, if the variable "Delta" is greater than "Released_Threshold", then the algorithm states that the button was not pressed. If the "Delta" is less than "Pressed_Threshold", then the algorithm states that the button was pressed, after that, while "Delta" is smaller than "Released_Threshold" the algorithm states that the button is still pressed. The algorithm will state that the button is no longer pressed, when "Delta" will be greater than "Released_Threshold". For a better understanding, the rules of functioning of a touch detection algorithm in reference to an exemplary course of the variable "Delta" are presented in Fig 5.

"Average_sensor_data" is a variable which adapts to an external condition and depends on the variable "Delta". If the algorithm detects the pressing of a button, "Average_sensor_data" will be increased by "DELTA" divided by 16. if the button is pressed, then:

$$\text{"Average\_sensor\_data"} = \text{"Average\_sensor\_data"} + \text{``Delta''} / 16$$

This adaptation of "Average_sensor_data" to external conditions, allows to turn off the detection of the pressing of long pressed keys.

If the algorithm does not detect the pressing of button, then "Average_sensor_data" will be increased by "Delta".

$$\text{"Average\_sensor\_data"} = \text{"Average\_sensor\_data"} + \text{``Delta''}$$

In Fig. 6 the sample courses s1, s2 and s3 which represent signals for three capacitive touch sensors are presented. Each one of these courses is obtained in a manner described in connection to Fig. 5. In other words, the courses s1, s2 and s3 represent calculated values "Word_Result" for particular capacitive touch sensors in the function of time. It is easy to notice the time of pressing the capacitive touch button and the accompanying decline of the corresponding course. In the figure, reference signs A, B and C enveloped by pillars schematically represent moments of a press detection by the processor of particular capacitive touch sensors activated in different times.

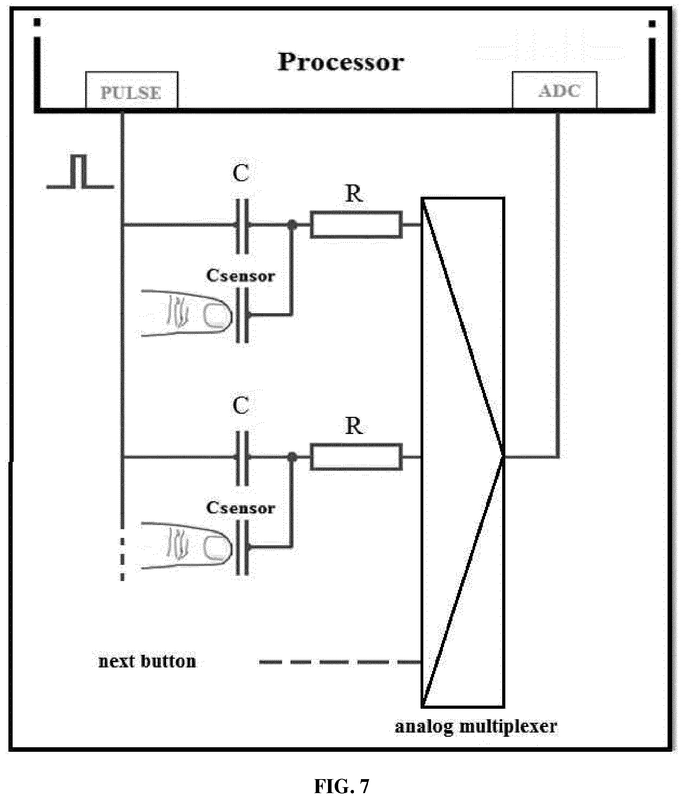

In Fig. 7 an exemplary electrical circuit arrangement employing an analog multiplexer for multiple capacitive touch sensors is presented. The analog multiplexer allows to connect multiple capacitive touch sensors Csensor in capacitive voltage divider circuit arrangements to the signal source PULSE. The output of the multiplexer is connected to the ADC input. In this example, the method provides a detection for multiple capacitive touch sensors. Although in the present embodiment an analog multiplexer is used, it should be noted that instead of the multiplexer any suitable line expander can be used. The solution in accordance with the present invention is simple. It does not depend on the processor platform and it requires a minimum number of components. It also presents a sufficiently high resistance to the EMI noise.

Although the principles of the present invention have been presented in connection to specific embodiments of the invention, a person skilled in the art will understand that the present solution is not limited thereto and other modifications and embodiments are possible that are covered by a scope of accompanying claims.

## Claims

1. A method of touch detection for capacitive touch sensors in a sensing circuit including a voltage/current source generating a variable output signal, connected to the capacitive touch sensor (Csensor) through an inverted polarized diode (D) having its cathode connected to the voltage/ current source, wherein the capacitive touch sensor (Csensor) and the inverted polarized diode (D) form a voltage divider, wherein the voltage stored on the capacitive touch sensor (Csensor) is measured by a measuring circuit connected through a resistor (R) to the capacitive touch sensor (Csensor), the method comprising the steps of:

   a) generating a variable level signal by a voltage/current source;
   b) starting a measurement immediately after the change of a signal level by the measuring circuit;
   c) storing a result of the measurement;
   d) repeating steps a), b) and c) a predetermined number of times;
   e) comparing the results obtained by the measuring circuit in order to determine a change of the measured signal indicative of a capacitance change of the capacitive touch sensor (Csensor).

2. The method according to claim 1, wherein the measurement is performed immediately after the signal changes its level from low to high or from high to low.

3. The method according to claim 1 or 2, wherein the measuring circuit is an analog-to-digital converter (ADC).

4. The method according to claim 1-3, wherein the measuring circuit is connected to the capacitive touch sensor (Csensor) through said resistor (R) and another electronic element providing a resistance to the electromagnetic interference (EMI).

5. The method according to claim 1-4, wherein the capacitive touch sensor (Csensor) is either a separate button or an element of a slider or a wheel.

6. The method according to claim 1-5, wherein the voltage/current source is connected via multiple inverted polarized diodes (D), which have their respective cathodes connected to the voltage/current source, to multiple capacitive touch sensors (Csensor), which are connected to the measuring circuit via multiple resistors (R) and a line expander.

7. The method according to claim 6 wherein the line expander is an analog multiplexer.

8. The method according to any of claims 1-7, wherein the voltage/current source and/or the measuring circuit are incorporated into an integrated circuit.

## Patentansprüche

1. Verfahren zur Berührungserfassung für kapazitive Berührungssensoren in einer Abtastschaltung, die eine Spannungs-/Stromquelle umfasst, die ein veränderliches Ausgangssignal erzeugt und mit dem kapazitiven Berührungssensor (Csensor) durch eine umgekehrt polarisierte Diode (D) verbunden ist, die ihre Kathode mit der Spannungs-/Stromquelle verbunden aufweist, wobei der kapazitive Berührungssensor (Csensor) und die umgekehrt polarisierte Diode (D) einen Spannungsteiler bilden, wobei die Spannung, die am kapazitiven Berührungssensor (Csensor) gespeichert wird, durch eine Messschaltung gemessen wird, die durch einen Widerstand (R) mit dem kapazitiven Berührungssensor (Csensor) verbunden ist, wobei das Verfahren die folgenden Schritte umfasst:

   a) Erzeugen eines Signals veränderlichen Pegels durch eine Spannungs-/Stromquelle;
   b) Beginnen mit einer Messung unmittelbar nach der Änderung eines Signalpegels durch die Messschaltung;
   c) Speichern eines Ergebnisses der Messung;
   d) Wiederholen der Schritte a), b) und c) eine vornestimmte Anzahl von Malen;

e) Vergleichen der durch die Messschaltung erhaltenen Ergebnisse, um eine Änderung des gemessenen Signals zu bestimmen, die eine Kapazitätsänderung des kapazitiven Berührungssensors (Csensor) anzeigt.

**2.** Verfahren nach Anspruch 1, wobei die Messung durchgeführt wird, unmittelbar nachdem das Signal seinen Pegel von niedrig auf hoch oder von hoch auf niedrig wechselt.

**3.** Verfahren nach Anspruch 1 oder 2, wobei die Messschaltung ein Analog-Digital-Wandler (ADC) ist.

**4.** Verfahren nach Anspruch 1 bis 3, wobei die Messschaltung mit dem kapazitiven Berührungssensor (Csensor) durch den Widerstand (R) und ein anderes elektronisches Element verbunden ist, das einen Widerstand gegen elektromagnetische Interferenz (EMI) bereitstellt.

**5.** Verfahren nach Anspruch 1 bis 4, wobei der kapazitive Berührungssensor (Csensor) entweder eine separate Taste oder ein Element eines Schiebers oder eines Rades ist.

**6.** Verfahren nach Anspruch 1 bis 5, wobei die Spannungs-/Stromquelle über mehrere umgekehrt polarisierte Dioden (D), die ihre jeweiligen Kathoden mit der Spannungs-/Stromquelle verbunden aufweisen, mit mehreren kapazitiven Berührungssensoren (Csensor) verbunden ist, die über mehrere Widerstände (R) und einen Leitungsexpander mit der Messschaltung verbunden sind.

**7.** Verfahren nach Anspruch 6 wobei der Leitungsexpander ein analoger Multiplexer ist.

**8.** Verfahren nach einem der Ansprüche 1 bis 7, wobei die Spannungs-/Stromquelle und/oder die Messschaltung in eine integrierte Schaltung eingebaut sind.

## Revendications

**1.** Procédé de détection de contact pour capteurs tactiles capacitifs dans un circuit de détection comprenant une source de tension/courant générant un signal de sortie variable, connecté au capteur tactile capacitif (Csensor) par l'intermédiaire d'une diode polarisée inversée (D) dont la cathode est connectée à la source de tension/courant, où le capteur tactile capacitif (Csensor) et la diode polarisée inversée (D) forment un diviseur de tension, où la tension stockée sur le capteur tactile capacitif (Csensor) est mesurée par un circuit de mesure connecté par l'intermédiaire d'une résistance (R) au capteur tactile capacitif (Csensor), le procédé comprenant les étapes suivantes :

a) générer un signal de niveau variable par une source de tension/courant ;
b) démarrer une mesure immédiatement après le changement d'un niveau de signal par le circuit de mesure ;
c) stocker un résultat de la mesure ;
d) répéter les étapes a), b) et c) un nombre prédéterminé de fois ;
e) comparer les résultats obtenus par le circuit de mesure afin de déterminer un changement du signal mesuré indicatif d'un changement de capacité du capteur tactile capacitif (Csensor).

**2.** Procédé selon la revendication 1, dans lequel la mesure est effectuée immédiatement après que le signal a changé son niveau de bas à haut ou de haut à bas.

**3.** Procédé selon la revendication 1 ou la revendication 2, dans lequel le circuit de mesure est un convertisseur analogique-numérique (ADC).

**4.** Procédé selon les revendications 1 à 3, dans lequel le circuit de mesure est connecté au capteur tactile capacitif (Csensor) à travers ladite résistance (R) et un autre élément électronique fournissant une résistance aux interférences électromagnétiques (EMI).

**5.** Procédé selon les revendications 1 à 4, dans lequel le capteur tactile capacitif (Csensor) est soit un bouton séparé, soit un élément d'un curseur ou d'une roue.

**6.** Procédé selon les revendications 1 à 5, dans lequel la source de tension/courant est connectée par l'intermédiaire de multiples diodes polarisées inversées (D), dont les cathodes respectives sont connectées à la source de tension/courant, à plusieurs capteurs tactiles capacitifs (Csensor), qui sont connectés au circuit de mesure par l'intermédiaire de plusieurs résistances (R) et d'un prolongateur de ligne.

**7.** Procédé selon la revendication 6, dans lequel le prolongateur de ligne est un multiplexeur analogique.

**8.** Procédé selon l'une quelconque des revendications 1 à 7, dans lequel la source de tension/courant et/ou le circuit de mesure sont intégrés dans un circuit intégré.

**FIG. 1**

**FIG. 2**

**FIG. 3**

S1 — START

S2 — Generate a variable level signal

S3 — Immediately start a measurement after the change of a signal level

S4 — Store a result of the measurement

S5 — Perform another measurement?

Y

N

S6 — Compare obtained results in order to determine the change of the measured signal indicative of a capacitance change of the capacitive touch sensor

**FIG. 4**

EP 2 722 988 B1

**FIG. 5**

**FIG. 6**

12

**FIG. 7**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7375656 B2
- US 20070181412 A1, Müller
- DE 102010030374 A1